# EUROPÄISCHE PATENTSCHRIFT

(11) **EP 1 683 890 B1**
(45) Veröffentlichungstag und Bekanntmachung des Hinweises auf die Patenterteilung: **10.12.2008**
(21) Anmeldenummer: 06001175.6
(22) Anmeldetag: 20.01.2006
(51) Int. Cl.: C23C 16/455

(54) **Verfahren zur Bildung einer dünnen Schicht auf einer Substratoberfläche**
Method for the formation of a thin layer on a substrate
Méthode de formation d'une couche mince sur un substrat silicium

(30) Priorität: 25.01.2005 DE 102005003336
(43) Veröffentlichungstag der Anmeldung: 26.07.2006
(73) Patentinhaber: Bte Bedampfungstechnik GmbH, 56479 Elsoff (DE)
(72) Erfinder: Feddersen-Clausen, Oliver, 52428 Jülich (DE)
(74) Vertreter: Meinke, Dabringhaus und Partner GbR

(56) Entgegenhaltungen:
- US-A- 4 413 022
- US-A1- 2003 143 328
- US-B1- 6 416 822
- SATOSHI TANIMOTO ET AL: "SYNCHRONOUSLY EXCITED DISCRETE CHEMICAL VAPOR DEPOSITION OF TA2O5" JOURNAL OF THE ELECTROCHEMICAL SOCIETY, ELECTROCHEMICAL SOCIETY. MANCHESTER, NEW HAMPSHIRE, US, Bd. 141, Nr. 5, 1. Mai 1994 (1994-05-01), Seiten 1339-1346, XP000470155 ISSN: 0013-4651
- KENJI HIRAMATSU ET AL: "FORMATION OF TIN FILMS WITH LOW CL CONCENTRATION BY PULSED PLASMA CHEMICAL VAPOR DEPOSITION" JOURNAL OF VACUUM SCIENCE AND TECHNOLOGY: PART A, AVS /AIP, MELVILLE, NY, US, Bd. 14, Nr. 3, PART 1, Mai 1996 (1996-05), Seiten 1037-1040, XP000620566 ISSN: 0734-2101
- LEE J-J ET AL: "Growth of diamond films from a continuous or interrupted CF4 supply" DIAMOND AND RELATED MATERIALS, ELSEVIER SCIENCE PUBLISHERS, AMSTERDAM, NL, Bd. 6, Nr. 2-4, März 1997 (1997-03), Seiten 511-515, XP004161044 ISSN: 0925-9635

## Beschreibung

Es sind verschiedene Verfahren zur Bildung einer dünnen Schicht bekannt. Am weitesten verbreitet ist der sogenannte PVD ("Physical Vapour Deposition")-Prozess. Hierbei wird das Schichtausgangsmaterial im Vakuum durch direktes Verdampfen oder durch Sputtern auf einer Substratoberfläche abgeschieden. Bei Bedarf wird gleichzeitig reaktives Prozessgas dem Reaktionsbereich zugeführt. Es werden dabei Prozesstemperaturen um die 300°C benötigt. Durch Unterstützung des Verfahrens mit Plasma (z.B. Ionenquellen) lässt sich die Prozesstemperatur senken; außerdem lassen sich die Schichteigenschaften verbessern.

Ein weiteres Verfahren wird als CVD ("Chemical Vapour Deposition")-Prozess bezeichnet und unterscheidet sich dadurch vom PVD-Prozess, dass das Schichtausgangsmaterial dampf- oder gasförmig dem Reaktionsbereich zugeführt wird, wobei meist chemische Verbindungen mit niedrigem Verdampfungspunkt gewählt werden. Die Schichtabscheidung erfolgt durch Zersetzung des schichtbildenden Prozessgases (Schichtausgangsmaterials) auf der Substratoberfläche. Hierzu wird das Substrat üblicherweise auf einige hundert °C geheizt. Bei Bedarf wird gleichzeitig reaktives Prozessgas dem Reaktionsbereich zugeführt. Durch Erzeugung von Plasma im Reaktionsbereich erfolgt direkte Gasphasenabscheidung des Schichtausgangsmaterials auf der Substratoberfläche und die Temperatur des Substrates kann deutlich reduziert werden. Dieses Verfahren wird als PECVD ("Plasma Enhanced Chemical Vapour Deposition")-Prozess bezeichnet. Die Druckschrift EP 0 849 769 A2 beschreibt ein derartiges Verfahren mit gepulster Plasmaerzeugung. Die Zufuhr von schichtbildendem und von reaktivem Prozessgas erfolgt gleichzeitig und kontinuierlich.

Verfahren mit zeitversetzter zyklischer Zufuhr von schichtbildendem und reaktivem Prozessgas, werden als ALD ("Atomic Layer Deposition")-Prozess bezeichnet. Hierbei wird ein dampf- oder gasförmiges Schichtausgangsmaterial (schichtbildendes Prozessgas) einem Reaktionsbereich zugeführt und von der Substratoberfläche adsorbiert. In einem Zwischenschritt wird der Reaktionsbereich gespült bzw. evakuiert. Nachfolgend wird ein zweites Prozessgas zugeführt, das mit dem auf der Substratoberfläche adsorbierten schichtbildenden Prozessgas reagiert (Oberflächenreaktion) und eine dünne Schicht bildet. Abschließend wird der Reaktionsbereich wieder gespült bzw. evakuiert. Diese Schrittfolge wird bis zum Erreichen der gewünschten Schichtdicke wiederholt. Die Auswahl geeigneter Prozessgase ist relativ kompliziert und der Prozess benötigt meist hohe Temperaturen, weshalb ALD-Verfahren mit Plasma-Unterstützung entwickelt wurden.

"SYNCHRONOUSLY EXCITED DISCRETE CHEMICAL VAPOR DEPOSITION OF TA205", Satoshi Tanimoto et al, Journal of the Electrochemical Society, Volume 141, No. 5, Seiten 1339-1346, 01-05-1994 offenbart ein Verfahren zur Bildung einer dünnen Schicht auf einer Substratoberfläche mit zeitversetzter zyklischer Zufuhr von Prozessgasen in einen Reaktionsbereich. Die Zufuhr der Prozessgase wird in den Reaktionsbereich durch zyklische Zuführpausen unterbrochen und innerhalb des Reaktionsbereichs wird Plasma eingeführt. Die Prozessgase und die Prozesstemperatur werden derart gewählt, dass eine Reaktion im Wesentlichen nur bei Erzeugung von Plasma erfolgt und während der Zufuhr von Prozessgasen in den Reaktionsbereich kein Plasma erzeugt wird.

Bei diesen sogenannten PEALD ("Plasma Enhanced Atomic Layer Deposition")-Prozessen wird reaktives Prozessgas durch Plasma aktiviert und zur Reaktion mit adsorbiertem schichtbildenden Prozessgas gebracht. In US 5 916 365 A wird jeweils nach der Zufuhr eines Prozessgases der Reaktionsbereich evakuiert, um Gasreste zu entfernen und die Zufuhr eines jeweils nächsten Prozessgases vorzubereiten. Dabei wird entweder eines der Prozessgase durch Plasma in Radikale zerlegt und dem Reaktionsbereich zugeführt oder während der Zufuhr des entsprechenden Prozessgases Plasma im Reaktionsbereich erzeugt. Für eine homogene Schichtdickenverteilung sind Gasphasenreaktionen auszuschließen, wodurch die zwischenliegenden Evakuierungsschritte viel Zeit in Anspruch nehmen.

Die Druckschrift WO 00/63957 A1 beschreibt ein Verfahren, in dem der Reaktionsbereich vor Zufuhr eines jeweils nächsten Prozessgases nicht evakuiert, sondern mit einem Spülgas gespült wird. Die Erzeugung von Plasma erfolgt während der Zufuhr eines reaktiven Prozessgases. In einer weiteren Ausgestaltung wird reaktives Prozessgas zuerst ohne Plasmaerzeugung zum Spülen verwendet, bevor während der weiteren Zufuhr die Erzeugung von Plasma erfolgt. WO 03/041142 A1 beschreibt ein Verfahren mit ständiger Zufuhr von reaktivem Prozessgas, das bei Erzeugung von Plasma reaktiv wird und ansonsten spülende Eigenschaften aufweist. Verfahren mit spülendem Prozessgas haben höhere Aufwachsraten als Verfahren mit Evakuierungsschritten, aber auch hier sind Gasphasenreaktionen zu vermeiden, so dass in der Regel Einzelsubstrate (Wafer) in kleinen auf die Substratform angepassten Reaktionsbereichen mit gezielter Strömungslenkung der Prozessgase beschichtet werden.

Herkömmliche ALD- und PEALD-Verfahren haben im Vergleich zu PVD- und CVD-Verfahren zwar hohe Schichthomogenität, jedoch geringe Aufwachsraten, so dass eine Anwendung für große Schichtdicken in der Regel nicht wirtschaftlich ist.

Aufgabe der Erfindung ist es, ein ALD-basiertes plasmaunterstütztes Verfahren mit hoher Schichthomogenität und hohen Aufwachsraten vorzuschlagen. Dabei wird die gleichzeitige Beschichtung mehrerer Substrate in vergleichsweise großen Reaktionsbereichen angestrebt. Das Verfahren soll vorwiegend für optische Beschichtungen Anwendung finden und die homogene Beschichtung beliebig geformter Substrate, wie z.B. Linsen oder Lampen (ohne spezielle Anpassungsmaßnahmen auf die Substratform) ermöglichen. Dabei wird aufgrund der sehr kompakten Schichtstruktur von im PEALD-Verfahren hergestellten dielektrischen Schichten eine Kombination von dielektrischen Schichten und eingebetteten dünnen Metallschichten, wie z.B. Silber, angestrebt. Zusätzlich soll das Verfahren eine umweltgerechte Beschichtung ermöglichen. Dabei sollen schichtbildende Prozessgase möglichst vollständig in dünne Schichten umgewandelt und schädliche Abgase in unschädliche verbrannt werden.

Diese Aufgabe wird bei einem Verfahren der eingangs bezeichneten Art erfindungsgemäß dadurch gelöst, dass die Zufuhr der Prozessgase in den Reaktionsbereich durch zyklische Zufuhrpausen unterbrochen wird, innerhalb derer im Reaktionsbereich Plasma erzeugt wird, und dass Prozessgase und Prozesstemperatur derart gewählt werden, dass eine Reaktion im Wesentlichen nur bei Erzeugung von Plasma erfolgt.

Bei dem erfindungsgemäßen Verfahren handelt es sich um ein plasmaunterstütztes Verfahren mit zeitversetzter zyklischer Prozessgaszufuhr und Schichtwachstum vorwiegend im Prinzip von Adsorption und Oberflächenreaktion (PEALD). Durch die in Anspruch 1 aufgeführten Merkmale bestehen zum Zeitpunkt der Erzeugung von Plasma keine Zufuhrströmungen durch Prozessgaszufuhr. Strömungslenkende Maßnahmen (z.B. auf die Geometrie der Substrate angepasste Düsensysteme, Gasduschen oder dergleichen) sind beim erfindungsgemäßen Verfahren daher nicht notwendig. Um unkontrollierte Reaktionen zwischen den Prozessgasen zu vermeiden, sind diese so zu wählen, dass sie ohne Plasma nicht bzw. nur wenig miteinander reagieren und die eigentliche Reaktion erst bei Erzeugung von Plasma erfolgt. Die Prozesstemperatur ist entsprechend abzustimmen. Besondere Eigenschaft der Erfindung ist es, dass die Prozessgase nur innerhalb der Zufuhrpausen miteinander reagieren und somit die eigentliche Schichtbildung ohne zufuhrbedingte Gasströmungen erfolgt.

Die zum Zufuhrpausenbeginn verzögerte Erzeugung von Plasma entsprechend Anspruch 2 ermöglicht eine homogene Verteilung der Prozessgase im gesamten Reaktionsbereich durch Druckausgleich und Gasmischung vor Reaktionsbeginn. Je nach Art der verwendeten Prozessgase kann es auch sinnvoll sein, die Erzeugung von Plasma vor Ende der Zufuhrpause zu stoppen, um Druckausgleich vor erneuter Gaszufuhr zu ermöglichen.

Weitere Zufuhrpausen ohne Erzeugung von Plasma entsprechend Anspruch 3 ermöglichen die homogene Verteilung eines ersten Prozessgases (z.B. zur Adsorption) vor der Zufuhr eines zweiten Prozessgases.

Entsprechend der Merkmale von Anspruch 4 sind Zufuhrpausenzyklus und Prozessgaswechsel miteinander synchron, wobei vorzugsweise nach einer Zufuhrpause ein anderes Prozessgas zugeführt wird als vor derselben.

Entsprechend Anspruch 5 ist die Erzeugung von Plasma auf die Zufuhrpausen begrenzt. Unter Berücksichtigung der Merkmale von Anspruch 2 werden somit unmittelbar vor als auch während der Erzeugung von Plasma dem Reaktionsbereich keine Prozessgase zugeführt.

Zusammenfassend bedeutet dies, dass der Reaktionsbereich aufgrund der Zufuhrpausen vor Zufuhr eines Prozessgases oder vor Erzeugung von Plasma mehr oder weniger gleiche Druck- und Mischungsverhältnisse aufweist. Daraus ergibt sich der wesentliche Vorteil, dass ein jeweiliges Prozessgas bereits überall im Reaktionsbereich zur Verfügung steht, bevor ein anderes Prozessgas zugeführt wird oder durch Erzeugung von Plasma Abgase entstehen.

Die Erzeugung von Plasma während der Zufuhr von Prozessgas würde dazu führen, dass das Prozessgas in der Nähe des Zufuhrbereichs bereits reagieren und Abgase bilden würde, bevor es die von der Prozessgaszufuhr weiter entfernten Bereiche erreichte. Der Abgasanteil im Prozessgas nähme dadurch mit wachsender Entfernung vom Zufuhrbereich zu, was zu ungleichmäßigen Schichteigenschaften im Reaktionsbereich (z.B. ungleiche Kohlenstoffeinlagerung, Oxidierung oder Schichtdicke) führen kann.

Ein weiterer Vorteil ergibt sich aus der Tatsache, dass bei gleichmäßiger Gasverteilung zum Zeitpunkt der Erzeugung von Plasma, zusätzlich zur Oberflächenreaktion eine gleichmäßige Gasphasenabscheidung der ggf. im Reaktionsbereich vorhandenen, nicht adsorbierten schichtbildenden Prozessgase erfolgen kann, sofern die Plasmaenergie ausreichend homogen ist. Dadurch sind hohe Aufwachsraten erzielbar, da Spül- bzw. Abpumpzeiten der Prozessgase deutlich verkürzt werden können.

Das Verfahren kann noch durch folgende Schritte und Schrittfolgen bevorzugt konkretisiert werden:

Es kann ein Zufuhrzyklus mit den Schritten
- Zufuhr eines schichtbildenden Prozessgases
- Zufuhr eines reaktiven Prozessgases und der Schrittfolge
- Zufuhrpausenabschnitt ohne Erzeugung von Plasma
- Zufuhrpausenabschnitt mit Erzeugung von Plasma
gebildet werden, wobei die Prozessgase und die Prozesstemperatur derart gewählt werden, dass eine Reaktion im Wesentlichen nur bei Erzeugung von Plasma erfolgt. Hiermit ist eine Reaktion zwischen den Prozessgasen gemeint, wobei mindestens eines der Prozessgase auf der Substratoberfläche adsorbiert sein kann. Die Adsorption eines Prozessgases kann unmittelbar durch Chemiesorption erfolgen. Es können im Zusammenhang mit der Adsorption eines Prozessgases aber auch Reaktionen an der Substratoberfläche (z.B. mit OH-Gruppen) ablaufen, ohne dass während dessen Plasma erzeugt wird.

Alternativ kann ein Zuführzyklus mit den Schritten
- Zufuhr eines schichtbildenden Prozessgases
- Zufuhr eines reaktiven Prozessgases und der Schrittfolge
- Zufuhrpause mit zumindest teilweiser Erzeugung von Plasma
- Zufuhr eines reaktiven Prozessgases
- Zufuhrpause mit mindestens teilweiser Erzeugung von Plasma
gebildet werden, wobei Prozessgase und Prozesstemperatur derart gewählt werden, dass eine Reaktion im Wesentlichen nur bei Erzeugung von Plasma erfolgt. Zusätzliche Schritte innerhalb eines Zyklus, wie z.B. weitere Zufuhrpausen oder Zufuhr weiterer schichtbildender oder reaktiver Prozessgase sind natürlich möglich. Diese Ausgestaltung stellt ein besonders umweltgerechtes Verfahren zur Verfügung, bei dem die in einer ersten Plasmareaktion entstandenen Abgase durch erneute Zufuhr eines reaktiven Prozessgases (z.B. Sauerstoff) und erneuter Plasmaerzeugung zu überwiegend unschädlichen Abgasen (z.B. Kohlendioxid) verbrannt werden.

Bei Verwendung organischer Prozessgase (z.B. Hexamethyldisiloxan) wird dadurch zusätzlich der Kohlenstoffanteil in der dünnen Schicht herabgesetzt. Die Verwendung eines reduzierenden Gases (z.B. Wasserstoff) und Reduktion der Abgase ist für bestimmte Anwendungen ebenso denkbar. Es können schichtbildende oder reaktive Prozessgase zeitgleich oder zumindest teilweise gleichzeitig eingebracht werden, um z.B. eine Erhöhung der Aufwachsrate zu erreichen.

Weitere Ausgestaltungen der Erfindung sind in den Ansprüchen 6 bis 12 dargestellt. Anspruch 6 betrifft die Druckdifferenz zwischen Gasdruck im Reaktionsbereich und Gasdruck des Prozessgases. Wird Prozessgas mit relativ hohem Gasdruck einem Reaktionsbereich zugeführt, so erfolgt eine schnelle Durchmischung des im Reaktionsbereich vorhandenen Gases mit dem neu zugeführten durch Druckausgleich. Weiterhin kann die benötigte Gasmenge bei höherem Differenzdruck in kürzerer Zeit zugeführt werden.

Anspruch 7 betrifft die Zufuhr von Prozessgasen in kurzen Pulsen. Die Merkmale der Ansprüche 6 und 7 ermöglichen bei gemeinsamer Anwendung sehr kurze Zykluszeiten, da Gaszufuhr und Gasverteilung im Millisekundenbereich anzuordnen sind und sich bei gleichmäßiger Gasverteilung und ausreichender Plasmaleistung auch sehr kurze Plasmapulse (im Millisekundenbereich) für die Schichtbildungsreaktion eignen.

Anspruch 8 betrifft die Anzahl der Substrate, wobei die zu beschichtende Substratoberfläche aus einer Vielzahl von Einzelsubstraten besteht. Das erfindungsgemäße Verfahren ermöglicht eine gleichzeitige Beschichtung vieler Substrate und ebenso eine recht kompakte Substratanordnung.

Anspruch 9 betrifft die Ausgestaltung des Reaktionsbereichs als Vakuumkammer. Idealerweise sollte während der Zufuhrpausen (insbesondere während der Plasmaerzeugung) keine Evakuierung des Reaktionsbereichs erfolgen, um Abpumpströmungen vollständig auszuschließen. Sinnvollerweise sollte der Reaktionsbereich jedoch zumindest während der Prozessgaszufuhr evakuiert werden, um einen Abtransport von Gasen zu gewährleisten. Eine kontinuierliche Evakuierung des Reaktionsbereichs ist vorteilhaft, da das ständige Öffnen und Schließen eines Absperrventils zwischen Reaktionsbereich und Pumpsystem (mit entsprechendem Verschleiß) somit nicht notwendig ist. Bei großflächigen Vakuumpumpen (z.B. Turbopumpen) und relativ niedrigen Prozessdrücken treten kaum Abpumpströmungen auf, welche die Schichthomogenität negativ beeinflussen. Vorteilhaft sind kurze Gaszufuhrpulse und Plasmaerzeugung direkt nach Gasverteilung, jedoch vor Abpumpen des Prozessgases. Dies wird durch eine hohe Zufuhrgeschwindigkeit der Prozessgase relativ zur Abpumpgeschwindigkeit ermöglicht. Gegebenenfalls kann eine Drosselung der Pumpleistung sinnvoll sein.

Auch die Erzeugung von Niedertemperatur-Plasma unter Atmosphärendruck ist inzwischen technisch realisierbar und eine Ausgestaltung des Reaktionsbereichs entsprechend Anspruch 10 kann eine Vereinfachung der Prozesstechnologie ermöglichen.

Im Gegensatz zu herkömmlichen CVD-Prozessen ohne Plasmaunterstützung müssen die im Reaktionsbereich befindlichen Substrate dann nicht beheizt werden, da eine Erwärmung der Substrate bereits durch die Erzeugung von Plasma erfolgt. Da die Schichteigenschaften in der Regel von der Plasmaleistung und nicht von der Pulslänge abhängig sind, kann die Prozesstemperatur entsprechend Anspruch 11 über die Pulslänge eingestellt werden. Bei Plasmapulsen größerer Länge kann zur Vermeidung reaktionsbedingter Gasströmungen eine Unterteilung der Pulse in jeweils mehrere Einzelpulse mit zwischenliegenden kurzen Plasmapausen vorteilhaft sein. Hierdurch sind Druckausgleich im Reaktionsbereich und gleichmäßige Verteilung von ggf. in plasmafreien Randbereichen befindlichen Prozessgasen möglich.

Anspruch 12 betrifft die bereits erwähnte gleichzeitige Schichtbildung durch Oberflächenreaktion (ALD) und Gasphasenabscheidung (CVD).

Unter Prozessgasen wird jegliche Form von Gasen und Dämpfen verstanden, die für die Bildung dünner Schichten dienlich sind. Die Prozessgase können schichtbildende, reaktive und spülende Eigenschaften aufweisen. Schichtbildende Prozessgase sind bei thermischer Zersetzung schichtbildend. Reaktive Prozessgase verändern die Eigenschaften einer Schicht (z.B. durch Oxidation mit Sauerstoff oder Reduktion mit Wasserstoff). Spülende Prozessgase spülen Prozess- und Abgase aus dem Reaktionsbereich.

Jedes der Prozessgase kann dabei über mehrere dieser Eigenschaften verfügen oder eine Mischung unterschiedlicher Gase sein. Erfindungsgemäße reaktive Prozessgase haben bei Prozesstemperatur zumeist spülende Eigenschaften und werden im Wesentlichen erst bei Erzeugung von Plasma reaktiv.

Ferner ist bevorzugt vorgesehen, dass die Zufuhr mindestens eines der Prozessgase durch Injektion einzelner Flüssigkeitsportionen in einen derart beheizten Bereich erfolgt, dass die Flüssigkeit in Dampf übergeht, wobei die Injektionspausen den Zufuhrpausen entsprechen. Dabei wird die Zufuhr der Flüssigkeitsportionen bevorzugt flussgeregelt, wobei weiterhin bevorzugt die Injektionspausen der Flussregelung durch empfangene oder gesendete Synchronisationssignale mit dem Zufuhrzyklus und der Erzeugung von Plasma abgestimmt werden. Ferner wird bevorzugt ein weiteres der Prozessgase dem beheizten Bereich des Injektors gepulst als Spülgas und somit indirekt dem Reaktionsbereich zugeführt.

Es kann somit ein Injektorsystem verwendet werden, das für herkömmliche CVD-Technologie mit einem kontinuierlich durch den beheizten Bereich strömenden Trägergas eingesetzt wird. Die Verwendung eines solchen Injektors, jedoch ohne Trägergas, ermöglicht die Nutzung der prinzipbedingten Injektionspausen als Zufuhrpausen. Dabei ist die Anbindung des beheizten Injektorbereichs an den Reaktionsbereich mit ausreichendem Leitungsquerschnitt und kurzer Leitungslänge vorzunehmen, so dass das durch Verdampfung einer Flüssigkeitsportion entstandene Prozessgas umgehend durch Druckausgleich dem Reaktionsbereich zugeführt wird und nicht langwierige Druckausgleichsströmungen nach der Verdampfung auftreten.

Sind derartige Druckausgleichsströmungen nicht vermeidbar, können Spülgaspulse (z.B. Argon) dem beheizten Injektorbereich jeweils nach Verdampfung einer Flüssigkeitsportion zugeführt werden, so dass die Druckausgleichsströmungen mit spülendem und nicht mit schichtbildendem oder reaktivem Prozessgas bei Erzeugung von Plasma erfolgen. Ebenso ist die zeitversetzte Injektion einer zu verdampfenden Spülflüssigkeit in den beheizten Injektorbereich mittels einer weiteren Injektionsdüse denkbar.

Bei flussgeregelter Flüssigkeitsinjektion werden Flussschwankungen durch Schwankungen des Flüssigkeitsdrucks oder thermische Effekte durch Anpassung der Pulslänge oder der Pulsfrequenz ausgeglichen. Hierfür ist natürlich eine Synchronisation der Flussregelung bzw. der Injektionspulse mit den anderen Zeitprozessen wie Plasmaerzeugung, Ventilschaltungen usw. erforderlich. Flussgeregelte Prozessgaszufuhr ist besonders dann von Vorteil, wenn ein merklicher Anteil der Schichtbildung über Gasphasenreaktion erfolgt und somit die Beschichtungsrate nicht nur von der Zyklenanzahl, sondern auch von der Prozessgasmenge abhängig ist. Im Weiteren ist eine umweltgerechtere Beschichtung möglich, da relativ genau die zur Adsorption oder Reaktion notwendige Prozessgasmenge zugeführt werden kann.

Injektorabhängig kann es sinnvoll sein, dass im Wechsel mit längeren Injektionspausen (Zufuhrpausen) mehrere Flüssigkeitsportionen direkt nacheinander injiziert werden.

Ferner kann bevorzugt vorgesehen sein, dass zumindest eines der Prozessgase flussgeregelt und kontinuierlich einem Vorratsvolumen und aus diesem mittels einer Absperrvorrichtung in Pulsen dem Reaktionsbereich zugeführt wird.

Die Erfindung ist nachstehend anhand der Zeichnung beispielhaft näher erläutert. Diese zeigt in
- Fig. 1: eine Prinzipskizze eines einfachen Beschichtungszyklus,
- Fig. 2: eine Prinzipskizze eines erweiterten Beschichtungszyklus,
- Fig. 3 (a - d): eine Prinzipdarstellung der Gasverteilung im Reaktionsbereich bei Erzeugung von Plasma in einer Zufuhrpause als Zeitsequenz,
- Fig. 4 (a - d): eine Prinzipdarstellung der Gasverteilung im Reaktionsbereich bei Gaseinlass während der Erzeugung von Plasma (Stand der Technik) als Zeitsequenz und
- Fig. 5: eine Prinzipskizze einer erfindungsgemäßen Beschichtungsvorrichtung.

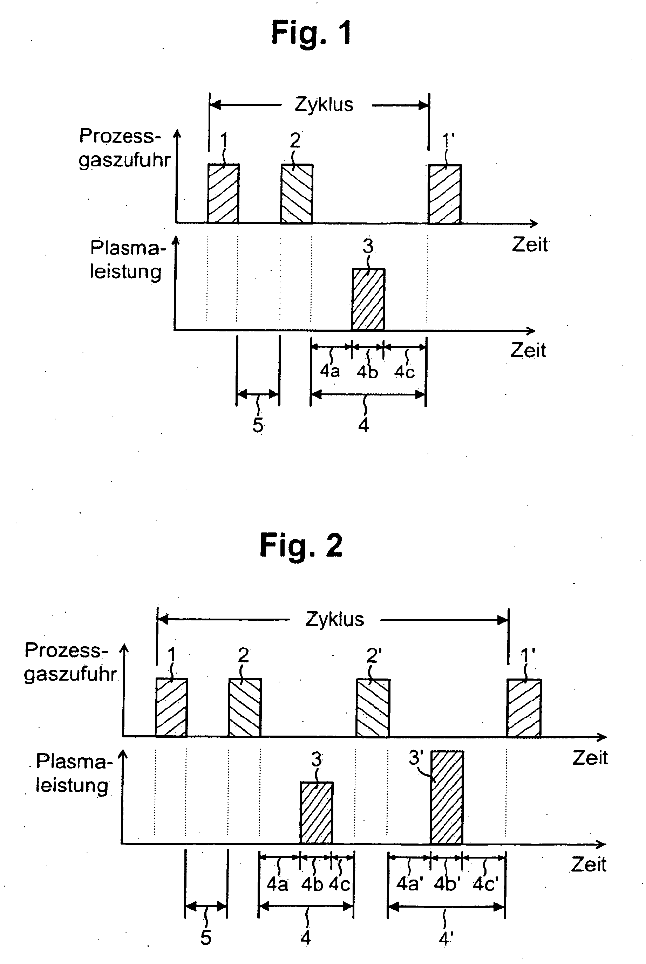

Ein erfindungsgemäßes Beispiel wird in Fig. 1 näher erläutert. In der Zeichnung ist ein Zyklus eines Beschichtungsvorgangs dargestellt. Dieser Zyklus wird bis zum Erreichen der gewünschten Schichtdicke wiederholt. In einem ersten Schritt wird ein vorzugsweise schichtbildendes Prozessgas 1 dem Reaktionsbereich zugeführt. Das schichtbildende Prozessgas 1 verteilt sich in der nachfolgenden plasmafreien Zufuhrpause 5 im Reaktionsbereich und wird von den Substratoberflächen adsorbiert. (Die Zufuhrpause ohne Erzeugung von Plasma 5 könnte derart lang ausgestaltet sein, dass überschüssiges Prozessgas 1 abgepumpt würde, dies ist jedoch zeitaufwendig und nicht vorgesehen.) In einem dritten Schritt wird ein vorzugsweise reaktives Prozessgas 2 dem Reaktionsbereich zugeführt. Das reaktive Prozessgas 2 verteilt sich in dem nachfolgenden plasmafreien Zufuhrpausenabschnitt 4a (der Zufuhrpause 4) im Reaktionsbereich. Im anschließenden Zufuhrpausenabschnitt 4b wird Plasma 3 erzeugt und durch Reaktion zwischen schichtbildendem Prozessgas 1 und reaktivem Prozessgas 2 eine dünne Schicht gebildet. Bei dieser Reaktion handelt es sich vorrangig um eine Oberflächenreaktion des von den Substratoberflächen adsorbierten schichtbildenden Prozessgases 1 mit dem im Reaktionsbereich befindlichen reaktiven Prozessgas 2.

Weiterhin erfolgt Gasphasenabscheidung durch Reaktion zwischen nicht adsorbiertem (also gasförmigem) schichtbildendem Prozessgas 1 und dem gasförmigen reaktiven Prozessgas 2. Ist diese zusätzliche Gasphasenabscheidung der dünnen Schicht (z.B. aufgrund ungleichmäßiger Schichtdickenverteilung oder abweichender Schichteigenschaften) nicht erwünscht, so kann das reaktive Prozessgas 2 in einem Vielfachen der für die Reaktion benötigten Menge zugeführt werden. Durch den resultierenden Druckanstieg im Reaktionsbereich wird im Zufuhrpausenabschnitt 4a zusätzlich zur Gasverteilung ein größerer Gasanteil abgepumpt oder abgeleitet und somit schichtbildendes Prozessgas 1 vor der Erzeugung von Plasma 3 aus dem Reaktionsbereich gespült. Ein weiterer plasmafreier Zufuhrpausenabschnitt 4c ermöglicht einen Druckausgleich im Reaktionsbereich bevor ein neuer Zyklus beginnt und schichtbildendes Prozessgas 1' zugeführt wird.

Wird als schichtbildendes erstes Prozessgas 1, 1' Hexamethyldisiloxan (HMDSO) und als reaktives zweites Prozessgas 2 Sauerstoff verwendet, hat ein Beschichtungszyklus zur Erzeugung von Siliziumdioxid folgende Schrittkette: Zufuhr von Hexamethyldisiloxan 1; plasmafreie Zufuhrpause 5; Zufuhr von Sauerstoff 2; Zufuhrpause 4 mit den Zufuhrpausenabschnitten 4a (ohne Plasma), 4b mit Erzeugung von Plasma 3 und 4c (ohne Plasma). Auf den Zufuhrpausenabschnitt 4c kann ggf. verzichtet werden; eine gleichmäßige Verteilung des schichtbildenden Prozessgases 1, 1' im Reaktionsbereich erfolgt jedoch schneller, wenn sich vor Zufuhr desselben gleiche Druckverhältnisse im Reaktionsbereich eingestellt haben.

Zur Bildung von Titandioxidschichten kann z.B. Tetraisopropylorthotitanat als schichtbildendes Prozessgas 1, 1' verwendet werden.

Fig. 2 ist ein weiteres erfindungsgemäßes Bespiel. Die Schrittfolge eines Zyklus entspricht Fig. 1, jedoch sind weitere Schritte angehängt. Dem Zufuhrpausenabschnitt 4c folgend, wird ein weiteres reaktives Prozessgas 2' zugeführt und im Anschluss folgt eine weitere Zufuhrpause 4' mit Zufuhrpausenabschnitten 4a', 4b', 4c', wobei im Zufuhrpausenabschnitt 4b' Plasma 3' erzeugt wird. Ist das erste Prozessgas 1 entsprechend dem ersten Beispiel Hexamethyldisiloxan und sind die nachfolgenden Prozessgase 2 und 2' jeweils Sauerstoff, so werden die im Zufuhrpausenabschnitt 4b durch einen ersten Plasmapuls 3 erzeugten Reaktionsabgase durch erneute Sauerstoffzufuhr 2' und nochmalige Erzeugung von Plasma 3' überwiegend in Kohlendioxid verbrannt. Der Zufuhrpausenabschnitt 4c sollte hierfür sehr kurz sein, damit wenig Reaktionsabgase vor vollständiger Verbrennung abgepumpt werden bzw. es kann auch ganz auf ihn verzichtet werden. Zur Verbrennung der Reaktionsabgase kann eine höhere Plasmaleistung des zweiten Plasmapulses 3' (im Vergleich zum ersten Plasmapuls 3) sinnvoll sein. Sollen hingegen die Reaktionsabgase ohne zusätzliche Verbrennung aus dem Reaktionsbereich gespült werden, so kann eine entsprechend große Menge Sauerstoff 2' zugeführt werden, die im nachfolgenden Zufuhrpausenabschnitt 4a' gemeinsam mit den Reaktionsabgasen größtenteils entweicht bzw. abgepumpt wird. Bei der nachfolgenden Erzeugung von Plasma 3' wirkt der reaktive Sauerstoff dann vorwiegend auf die bereits gebildete Siliziumdioxidschicht ein.

Es sind unzählige schichtbildende Prozessgase, eine Vielzahl reaktiver Prozessgase, beliebige Prozessgaskombinationen innerhalb eines Zyklus und beliebige Kombinationen von Zufuhrzyklen möglich. Dadurch können Gradientenindexschichten, Mehrlagenschichtsysteme, Kolloide und dergleichen erzeugt werden.

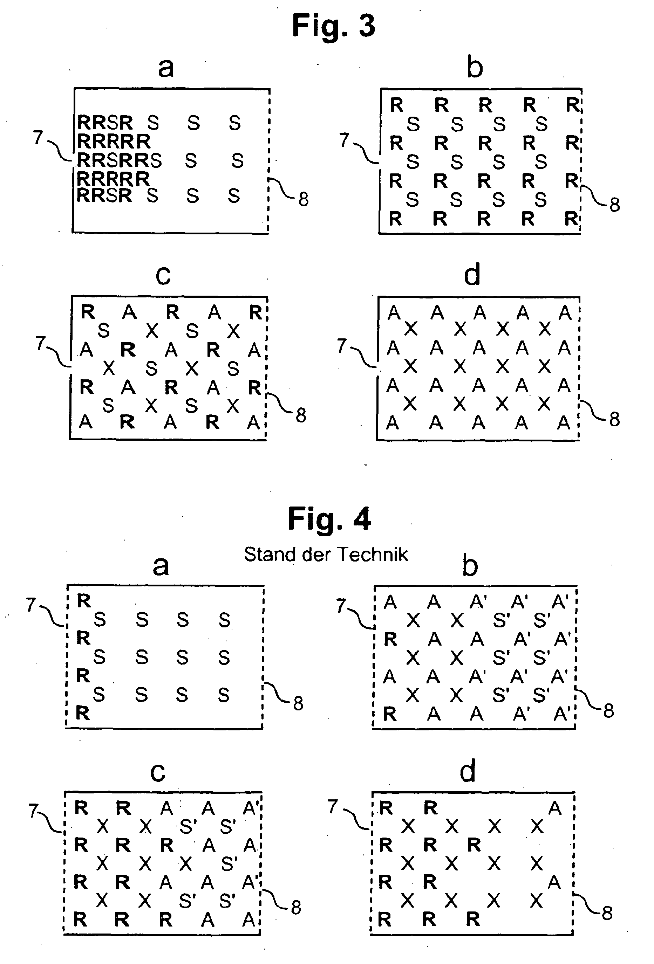

Fig. 3 (a - d) zeigt eine kurze Sequenz des erfindungsgemäßen Verfahrens. In Prinzipdarstellung wird ein Zeitverlauf von Gasverteilung und Plasmareaktion in einem Reaktionsbereich dargestellt. Dabei sind Gasdichte und Gasverteilung durch eine Vielzahl gleicher Buchstaben dargestellt. Unterschiedliche Buchstaben zeigen die Art des Prozessgases bzw. den Reaktionszustand an. Fig. 3a zeigt die Zufuhr eines reaktiven Prozessgases R durch eine Zufuhröffnung 7. Schichtbildendes Prozessgas S befindet sich bereits im Reaktionsbereich gleichmäßig verteilt (adsorbiert auf gleichmäßig im Reaktionsbereich verteilten Substraten). Der Gasaustrittsbereich 8 ist auf der rechten Seite des Reaktionbereichs gestrichelt dargestellt und kann geöffnet oder geschlossen sein. Fig. 3b zeigt den gleichen Reaktionsbereich wenige Millisekunden später. Das reaktive Prozessgas R hat sich nach dem Zufuhrpuls innerhalb einer Zufuhrpause durch Druckausgleich und Gasmischung gleichmäßig im Reaktionsbereich verteilt. In Fig. 3c ist die nachfolgende Erzeugung von Plasma dargestellt. Durch Reaktion von schichtbildendem Prozessgas S mit reaktivem Prozessgas R entstehen Abgas A und auf den Substraten dünne Schichten X. Zum Darstellungszeitpunkt ist die Reaktion zur Hälfte erfolgt. Fig. 3d zeigt den Reaktionsbereich nach vollständiger idealer Reaktion. Es verbleiben dünne Schichten X und Abgas A im Reaktionsbereich. Im folgenden (nicht dargestellt) kann bevorzugt das Abgas A durch einen Zufuhrpuls von spülendem Prozessgas (z.B. Argon oder Krypton) aus dem Reaktionsbereich (durch den Gasaustrittsbereich 8) gespült und die Oberfläche der Substrate durch einen weiteren Plasmapuls zur Chemisorption (Adsorption) aktiviert werden.

Fig. 4 (a - d) zeigt eine kurze Sequenz eines Verfahrens nach dem Stand der Technik. In Prinzipdarstellung wird ein Zeitverlauf von Gasverteilung und Plasmareaktion in einem Reaktionsbereich dargestellt. Dabei sind Gasdichte und Gasverteilung durch eine Vielzahl gleicher Buchstaben dargestellt. Unterschiedliche Buchstaben zeigen die Art des Prozessgases bzw. den Reaktionszustand an.

Fig. 4a zeigt den Beginn der Zufuhr eines reaktiven Prozessgases R durch einen Zufuhrbereich 7. Schichtbildendes Prozessgas S befindet sich bereits im Reaktionsbereich gleichmäßig verteilt (adsorbiert auf gleichmäßig im Reaktionsbereich verteilten Substraten). Zufuhrbereich 7 und Gasaustrittsbereich 8 sind gestrichelt dargestellt und kontinuierlich geöffnet, so dass eine kontinuierliche Prozessgasströmung durch den Reaktionsbereich von links nach rechts verläuft. Die Darstellung der Sequenz Fig. 4a bis Fig. 4d erfolgt in etwa gleichen Zeitabschnitten und ausgenommen von Fig. 4a wird kontinuierlich Plasma erzeugt. In Fig. 4b ist der Reaktionsbereich unmittelbar nach Plasmabeginn dargestellt und das reaktive Prozessgas R ist bereits bis zur Mitte des Reaktionsbereichs vorgedrungen.

Aufgrund der Erzeugung von Plasma hat jedoch in diesem Bereich (linke Hälfte des Reaktionsbereichs) bereits eine Umwandlung von reaktivem Prozessgas R und schichtbildendem Prozessgas S in Abgas A und dünne Schichten X stattgefunden und nur in direkter Nähe des Zufuhrbereichs 7 befindet sich nachströmendes Prozessgas R. Zusätzlich hat in der rechten Hälfte des Reaktionsbereichs durch Plasmaeinwirkung eine Zersetzung des schichtbildenden Prozessgases S in ein Schichtzwischenprodukt S' und ein gasförmiges Abspaltungsprodukt A' stattgefunden (es wird von Plasmaerzeugung im gesamten Reaktionsbereich ausgegangen.) In Fig. 4c ist das Abgas A von der linken Hälfte in die rechte Hälfte des Reaktionsbereichs geströmt. In der linken Hälfte befindet sich nachgeströmtes reaktives Prozessgas R, das auf die bereits entstandenen dünnen Schichten X einwirkt. In der rechten Hälfte hingegen wirkt Abgas A auf das Schichtzwischenprodukt S' ein, was gegebenenfalls zu Wechselwirkungen, nicht jedoch zur Bildung der gewünschten dünnen Schichten X führt. Das gasförmige Abspaltungsprodukt A' ist durch den Gasaustrittsbereich 8 entwichen.

In Fig. 4 d hat das reaktive Prozessgas R den gesamten Reaktionsbereich erreicht und in der rechten Hälfte das Schichtzwischenprodukt S' durch Plasmareaktion in dünne Schichten X umgewandelt. Dabei entstehen gegebenenfalls keine oder nur sehr wenig Abgase, da ja bereits gasförmige Abspaltungsprodukte A' abgeführt wurden. In der linken Hälfte befindet sich schon wieder nachgeströmtes reaktives Prozessgas R. Dies bedeutet, dass im Zufuhrbereich 7 (linke Hälfte) reaktives Prozessgas R viel länger auf die Substrate einwirkt als im Gasaustrittsbereich 8 (rechte Hälfte). Des Weiteren durchströmen die Abgase A während der Plasmaerzeugung den Reaktionsbereich von links nach rechts, so dass der Einfluss der Abgase A auf die Beschichtung im Zufuhrbereich 7 vernachlässigbar und im Gasaustrittsbereich 8 am größten ist. Würde die Erzeugung von Plasma verzögert zum Zufuhrbeginn des reaktiven Prozessgases R erfolgen, so dass bei Plasmabeginn bereits im gesamten Reaktionsbereich reaktives Prozessgas R (entsprechend Fig. 3b) vorhanden wäre, so würde die eigentliche Plasmareaktion (Umwandlung von R und S in A und X) zwar im gesamten Reaktionsbereich zeitgleich erfolgen, durch das während der Plasmaerzeugung weiterströmende reaktive Prozessgas R ergäbe sich jedoch auch hier eine längere Einwirkzeit von plasmaaktiviertem, reaktivem Prozessgas R im Zufuhrbereich 7 und entsprechend im Gasaustrittsbereich 8 eine längere Einwirkzeit von plasmaaktiviertem Abgas A. Diese bei Beginn der Plasmaerzeugung ungleiche Gasverteilung ließe sich mit entsprechendem Zeitverlust durch lange Zufuhrzeiten von reaktivem Prozessgas R, bei gleichzeitiger Erzeugung von Plasma, etwas relativieren. Bei herkömmlichen Anwendungen von plasmaunterstützten ALD-Prozessen werden meist einzelne Wafer (Rohlinge für die Mikroelektronik) beschichtet, die plan sind und durch Standardgrößen gezielt mit Prozessgasen umströmt werden können. Soll eine Vielzahl möglichst beliebig geformter Substrate gleichzeitig homogen beschichtet werden, so sind bei herkömmlichen Beschichtungsverfahren Zufuhrströmungen und inhomogene Gasverteilungen während der Plasmaerzeugung kaum zu beherrschen. Auch die Zufuhr bereits plasmaaktivierter Reaktivgase (Radikale) führt diesbezüglich zu keiner Verbesserung.

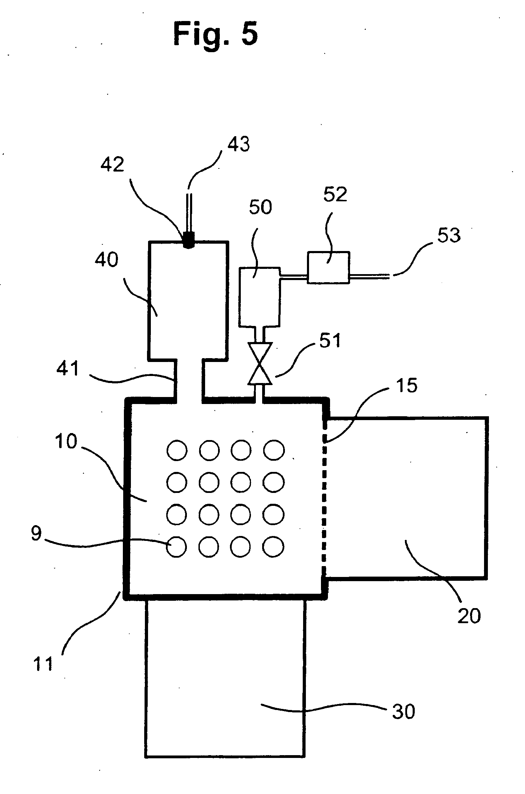

Fig. 5 ist eine Prinzipdarstellung einer erfindungsgemäßen Beschichtungsvorrichtung. In einem Reaktionsbereich 10 ist eine Vielzahl von Substraten 9 (ggf. dreidimensional) angeordnet. Eine Pumpvorrichtung 20 dient zur Evakuierung des von einer Kammerwand 11 umschlossenen Reaktionsbereichs 10. Im Gasaustrittsbereich 15 des Reaktionsbereichs 10 können Mittel zur Absperrung und/oder Drosselung der Pumpvorrichtung sowie ggf. Mittel zur Strömungsreduktion vorgesehen sein. Ein Plasmagenerator 30 ermöglicht die Erzeugung von Plasma im Reaktionsbereich 10. Je nach Prozessdruck kann z.B. RF- oder Mikrowellentechnologie zur Plasmaerzeugung eingesetzt werden. Derart angeregtes Plasma wird auch Niedertemperaturplasma genannt. Zur effektiven Nutzung des erfindungsgemäßen Verfahrens sollte das im Reaktionsbereich 10 erzeugte Plasma im Bereich der Substrate 9 möglichst homogen sein. Dem Fachmann sind unterschiedlichste Verfahren zur Erzeugung entsprechender Plasmen bekannt, weshalb auf eine Darstellung von Durchführungen, Antennen oder dergleichen verzichtet wurde.

Die Zufuhr von Prozessgasen in den Reaktionsbereich 10 erfolgt einerseits mittels einer Injektionsdüse 42 durch Injektion von Flüssigkeitsportionen in einen beheizten Bereich 40 und Zufuhr des durch Verdampfung im beheizten Bereich 40 entstandenen Prozessgases über ein Verbindungselement 41 in den Reaktionsbereich 10. Die Zufuhr in den Reaktionsbereich 10 erfolgt durch Druckausgleich des beim Verdampfen einer Flüssigkeitsportion entstehenden Überdrucks. Das Verbindungselement 41 kann beheizt sein. Die Flüssigkeitszufuhr erfolgt über eine Zufuhrleitung 43 mit oder ohne Flussregelung. Andererseits ist eine Vorrichtung zur flussgeregelten Erzeugung von Zufuhrpulsen unter Verwendung eines Ventils (Absperrvorrichtung) 51 dargestellt. Dabei wird Prozessgas durch eine Zufuhrleitung 53 einem Flussregler 52 und flussgeregelt einem Vorratsvolumen 50 zugeführt. Die Zufuhr des Prozessgases aus dem Vorratsvolumen 50 in den Reaktionsbereich 10 erfolgt in Pulsen durch zyklisches kurzes Öffnen und anschließendes Schließen des Ventils 51. Die Öffnungsdauer sollte relativ zur Sperrdauer kurz gewählt sein, da bei Druckschwankungen im Vorratsvolumen 50 kurzzeitig Regelschwankungen der Flussregelung 52 auftreten können. Um ein Nachströmen des Prozessgases zu vermeiden, ist das Ventil 51 nah am Reaktionsbereich 10 anzuordnen, so dass beim Öffnen des Ventils 51 eine direkte Zufuhr des Prozessgases in den Reaktionsbereich 10 erfolgt. Ventil 51, Vorratsvolumen 50, Flussregler 52 und Zufuhrleitung 53 können je nach Art des verwendeten Gases bzw. Dampfes beheizt sein. Die Beschichtungsvorrichtung kann mit mehreren beheizten Bereichen 40 und mehreren Vorratsvolumen 50 ausgestattet sein. Dabei kann jeder beheizte Bereich 40 mehrere Injektionsdüsen 42 und jedes Vorratsvolumen 50 mehrere Flussregler 52 zur Gaszufuhr aufweisen. Die gepulste Zufuhr von Prozessgasen kann auch direkt mittels einer Absperrvorrichtung 51 ohne Flussregelung 52 und Vorratsvolumen 50 erfolgen. Die Steuerung des Ventils 51, der Injektordüse 42 und des Plasmagenerators 30 erfolgt aufeinander abgestimmt.

## Patentansprüche

1. Verfahren zur Bildung einer dünnen Schicht auf einer Substratoberfläche mit zeitversetzter zyklischer Zufuhr von Prozessgasen in einen Reaktionsbereich, wobei die Zufuhr der Prozessgase in den Reaktionsbereich durch zyklische Zufuhrpausen unterbrochen wird, innerhalb derer im Reaktionsbereich Plasma erzeugt wird, und wobei Prozessgase und Prozesstemperatur derart gewählt werden, dass eine Reaktion im Wesentlichen nur bei Erzeugung von Plasma erfolgt, wobei während der Zufuhr von Prozessgasen in den Reaktionsbereich kein Plasma erzeugt wird.

2. Verfahren nach Anspruch 1,
**dadurch gekennzeichnet,**
**dass** die Erzeugung von Plasma verzögert zum Zufuhrpausenbeginn durchgeführt wird.

3. Verfahren nach Anspruch 1,
**dadurch gekennzeichnet,**
**dass** die Zufuhr der Prozessgase in den Reaktionsbereich durch weitere zyklische Zufuhrpausen unterbrochen wird, innerhalb derer kein Plasma erzeugt wird.

4. Verfahren nach einem der vorangegangenen Ansprüche,
**dadurch gekennzeichnet,**
**dass** die Zufuhrpausen mit dem Wechsel der Prozessgase synchronisiert werden.

5. Verfahren nach einem der vorangegangenen Ansprüche,
**dadurch gekennzeichnet,**
**dass** die Zufuhr mindestens eines der Prozessgase mit hohem Differenzdruck relativ zum Gasdruck im Reaktionsbereich durchgeführt wird.

6. Verfahren nach einem der vorangegangenen Ansprüche,
**dadurch gekennzeichnet,**
**dass** die Zufuhr mindestens eines der Prozessgase in kurzen Pulsen relativ zur Zufuhrpausenlänge durchgeführt wird.

7. Verfahren nach einem der vorangegangenen Ansprüche,
**dadurch gekennzeichnet,**
**dass** eine Vielzahl von Substraten im Reaktionsbereich angeordnet wird.

8. Verfahren nach einem der vorangegangenen Ansprüche,
**dadurch gekennzeichnet,**
**dass** der Reaktionsbereich als Reaktionskammer ausgeführt wird, die mittels einer Pumpvorrichtung evakuierbar ist.

9. Verfahren nach einem der Ansprüche 1 bis 7,
**dadurch gekennzeichnet,**
**dass** die Erzeugung von Plasma bei Atmosphärendruck und derart offenem Reaktionsbereich durchgeführt wird, dass überschüssige Prozess- und Abgase aus dem Reaktionsbereich durch Druckausgleich abgeleitet werden.

10. Verfahren nach einem der vorangegangenen Ansprüche,
**dadurch gekennzeichnet,**
**dass** die Einstellung der Prozesstemperatur im Reaktionsbereich über die Plasmapulslänge durchgeführt wird.

11. Verfahren nach einem der vorangegangenen Ansprüche,
**dadurch gekennzeichnet,**
**dass** ein Anteil nicht adsorbierten schichtbildenden Prozessgases bei Erzeugung von Plasma im Reaktionsbereich belassen wird, so dass Oberflächenreaktion und Gasphasenabscheidung gleichzeitig durchgeführt werden.

## Claims

1. A method of forming a thin layer on a substrate surface comprising time-shifted cyclic feed of process gases into a reaction region, wherein the feed of the process gases into the reaction region is interrupted by cyclic feed pauses, within which plasma is generated in the reaction region and wherein process gases and process temperature are so selected that a reaction occurs substantially only upon generation of plasma, wherein no plasma is generated during the feed of process gases into the reaction region.

2. A method according to claim 1 **characterised in that** the generation of plasma is implemented in delayed relationship with the beginning of feed pauses.

3. A method according to claim 1 **characterised in that** the feed of the process gases into the reaction region is interrupted by further cyclic feed pauses, within which no plasma is generated.

4. A method according to one of the preceding claims **characterised in that** the feed pauses are synchronised with the change in the process gases.

5. A method according to one of the preceding claims **characterised in that** the feed of at least one of the process gases is effected with a high differential pressure relative to the gas pressure in the reaction region.

6. A method according to one of the preceding claims **characterised in that** the feed of at least one of the process gases is effected in short pulses relative to the feed pause length.

7. A method according to one of the preceding claims **characterised in that** a multiplicity of substrates is arranged in the reaction region.

8. A method according to one of the preceding claims **characterised in that** the reaction region is in the form of a reaction chamber which can be evacuated by means of a pump device.

9. A method according to one of claims 1 to 7 **characterised in that** the generation of plasma is effected at atmospheric pressure and with a reaction region which is open in such a way that excess process and waste gases are discharged from the reaction region by pressure equalisation.

10. A method according to one of the preceding claims **characterised in that** adjustment of the process temperature in the reaction region is effected by way of the plasma pulse length.

11. A method according to one of the preceding claims **characterised in that** a portion of non-adsorbed layer-forming process gas is left in generation of plasma in the reaction region so that the surface reaction and gas phase deposit are effected at the same time.

## Revendications

1. Procédé en vue de la formation d'une couche mince sur une surface de substrat avec un apport cyclique décalé dans le temps de gaz de procédé vers une zone réactionnelle, l'apport des gaz de procédé vers la zone réactionnelle étant interrompu par des pauses cycliques d'apport, au cours desquelles un plasma est produit dans la zone réactionnelle et les gaz de procédé et la température de procédé étant sélectionnés de telle sorte qu'une réaction ne se fasse pour l'essentiel que dans le cas de la production de plasma, aucun plasma n'étant produit pendant l'apport des gaz de procédé vers la zone réactionnelle.

2. Procédé selon la revendication 1, **caractérisé en ce que** la production de plasma est effectuée avec un décalage dans le temps par rapport au début des pauses d'apport.

3. Procédé selon la revendication 1, **caractérisé en ce que** l'apport des gaz de procédé vers la zone réactionnelle est interrompu par des pauses d'apport cycliques supplémentaires, au cours desquelles aucun plasma n'est produit.

4. Procédé selon l'une quelconque des revendications précédentes, **caractérisé en ce**
**que** les pauses d'apport sont synchronisées avec le changement des gaz de procédé.

5. Procédé selon l'une quelconque des revendications précédentes, **caractérisé en ce que** l'apport d'au moins un des gaz de procédé est effectué avec une pression différentielle élevée par rapport à la pression gazeuse vers la zone réactionnelle.

6. Procédé selon l'une quelconque des revendications précédentes, **caractérisé en ce que** l'apport d'au moins un des gaz de procédé est effectué en pulsations courtes par rapport à la longueur des pauses d'apport.

7. Procédé selon l'une quelconque des revendications précédentes, **caractérisé en ce qu'**une pluralité de substrats est disposée dans le domaine de réaction.

8. Procédé selon l'une quelconque des revendications précédentes, **caractérisé en ce que** la zone réactionnelle est réalisée sous forme d'une chambre de réaction qui peut être évacuée à l'aide d'un dispositif de pompe.

9. Procédé selon l'une quelconque des revendications 1 à 7, **caractérisé en ce que** la production de plasma est effectuée à la pression atmosphérique et dans une zone réactionnelle ouverte de telle sorte que les gaz de procédé et les gaz de rejet en excès puissent être évacués hors de la zone réactionnelle par un équilibrage de la pression.

10. Procédé selon l'une quelconque des revendications précédentes, **caractérisé en ce que** le réglage de la température de procédé dans la zone réactionnelle est effectué par l'intermédiaire de la longueur des pulsations de plasma.

11. Procédé selon l'une quelconque des revendications précédentes, **caractérisé en ce qu'**une proportion du gaz de procédé formant une couche, non adsorbé lors de la production de plasma est laissée dans la zone réactionnelle, de telle sorte que des réactions superficielles et un dépôt en phase gazeuse puissent être effectués simultanément.
